# EUROPÄISCHE PATENTANMELDUNG

(11) **EP 4 312 055 A1**
(43) Veröffentlichungstag der Anmeldung: **31.01.2024**
(21) Anmeldenummer: 23176068.7
(22) Anmeldetag: 30.05.2023
(51) Int. Cl.: G01S 7/481

(54) **OPTOELEKTRONISCHER SENSOR ZUR ERFASSUNG VON OBJEKTEN IN EINEM ÜBERWACHUNGSBEREICH**

(30) Priorität: 28.07.2022 DE 102022118959
(71) Anmelder: SICK AG, 79183 Waldkirch (DE)
(72) Erfinder: Kornmayer, Jens, 79106 Freiburg (DE); Baumgartner, August, 79280 Au (DE); Kaupmann, Philip, 79194 Gundelfingen (DE)

(57) **Zusammenfassung**

Um einen verbesserten Wärmeaustausch eines optoelektronischen Sensors an seine Umgebung zu erreichen, umfasst der optoelektronische Sensor (S) zur Erfassung von Objekten in einem Überwachungsbereich,
- eine rotierende Optikeinheit (1) mit mindestens einem Lichtsender (4) zum Aussenden von Sendelichtstrahlen (SL), mindestens einem Lichtempfänger (5) zum Empfangen von Empfangslicht (EL), das von Objekten im Überwachungsbereich remittiert ist, und zugehöriger Elektronik (6) zur Steuerung der Optikeinheit (1),
- eine Antriebseinheit (2) zum Rotieren der Optikeinheit (1),
- ein Gehäuse (3) zur Umhausung wenigstens der Optikeinheit (1), wobei das Gehäuse (3) wenigstens einen Sendelichtstrahl und Empfangslicht (SL und EL) durchlässigen Fensterbereich aufweist, und
- Wärmetausch-Elemente (8), die an der Optikeinheit (1) außenseitig vorgesehen sind und derart angeordnet sind, dass die Wärmetausch-Elemente (8) mit der Optikeinheit (1) rotieren und Flachseiten (8A) der Wärmetausch-Elemente (8) in einem definierten Abstand (A) zu einer Innenseite (I) des Gehäuses (3) liegen, um einen konvektiven Wärmeaustausch mit dem Gehäuse (3) bereitzustellen.

## Beschreibung

Die Erfindung betrifft einen optoelektronischen Sensor zur Erfassung von Objekten in einem Überwachungsbereich umfassend eine rotierende Optikeinheit mit Lichtsender, Lichtempfänger und zugehöriger Elektronik, eine Antriebseinheit zum Rotieren der Optikeinheit, ein statisches Gehäuse mit einem Fensterbereich, wobei die Optikeinheit Wärmetausch-Elemente aufweist, die mit der Optikeinheit rotieren und die Flachseiten aufweisen.

Laserscanner eignen sich besonders gut für Abstandmessungen, die einen großen horizontalen Winkelbereich eines Überwachungsbereiches erforderlich machen. Hierbei überstreicht ein von einem Lichtsender, in Form eines Lasers, erzeugter Lichtstrahl als Sendelichtstrahl periodisch den Überwachungsbereich. Der Sendelichtstrahl wird an Objekten in dem Überwachungsbereich remittiert und von einem Lichtempfänger empfangen. Das empfangene Licht, im Folgenden als Empfangslicht bezeichnet, wird in dem Laserscanner mittels einer Elektronik ausgewertet.

Der Lichtsender, der Lichtempfänger und die zugehörige Elektronik werden in einer rotierenden Optikeinheit zusammengefasst. Aus der Winkelstellung einer Drehwelle des Sensors, an die die Optikeinheit angebracht ist, wird auf die Winkellage des Objektes, und aus der Lichtlaufzeit unter Verwendung der Lichtgeschwindigkeit zusätzlich auf die Entfernung des Objektes vom Sensor geschlossen. Mit den Winkel- und Entfernungsdaten ist ein Objekt in dem Überwachungsbereich ortsaufgelöst erfasst.

Durch die steigende Leistungsfähigkeit der Elektronik und die kompaktere Bauweise des Sensors ist eine hohe Wärmeentwicklung im Sensor gegeben, die durch passive Kühlung, wie z.B. Wärmepads, nicht zufriedenstellend lösbar ist, so dass eine Einhaltung einer zulässigen Betriebstemperatur des Sensors schwierig ist. Eine höhere Gerätetemperatur hat auch negative Auswirkung auf eine Lebensdauer und eine Leistung des Sensors.

Bei bekannten Laserscannern, bei denen die Elektronik in statischen Gehäuseteilen angeordnet ist, lässt sich die Wärme direkt an das Gehäuse des Laserscanners ableiten, so dass ein Wärmeaustausch zwischen Laserscanner und Umgebung ermöglicht ist.

Bei einem Vorsehen der Elektronik in der rotierenden Optikeinheit (Rotor) ist eine direkte Ableitung der Wärme der Elektronik an das Gehäuse nicht ohne erheblichen konstruktiven Aufwand möglich. Ein Einsatz von mechanischen Bauteilen aus Metall zur Verbesserung der Wärmeleitung wirkt sich negativ auf den Rotor aus, denn das erfordert einen größeren Motor mit höherer Traglast, was geringere Robustheit gegenüber Umweltbelastung (Schock/Vibration) bewirkt. Weiter führt dies zu mehr Leistungsaufnahme des Geräts und damit wiederum zu einem höheren Energieverbrauch und Wärmeeintrag. Eine Wärmeabfuhr über das Lager, die Lagerwelle und den Motor ist stark eingeschränkt aufgrund der geringen Wärmeabfuhr dieser Komponenten. Die Wärme könnte auch durch die den Rotor umgebende Luft abgeführt werden, aber durch die konstante Rotation bildet sich eine stabile Strömung in Drehrichtung aus, so dass die relative Geschwindigkeit der Luft in der Nähe der Wärmequellen der rotierenden Optikeinheit sehr gering ist. Die Luft erwärmt sich zwar, es findet jedoch kaum Verwirbelung statt und somit ist der Wärmetransport reduziert. Auch entstehen durch mechanische Elemente, vor allem Optiken, Bereiche, die bzgl. der Luftströmung abgeschattet sind. Es bilden sich Taschen, von denen aus fast kein konvektiver Wärmetransport stattfindet. Insgesamt ist der Wärmeaustausch zwischen der rotierenden Elektronik und dem statischen Gehäuse und damit der Umgebung unzureichend.

Die DE 102018214598 A1 offenbart eine Baugruppe für einen Umgebungssensor, wobei die Baugruppe ein Gehäuse und einen in dem Gehäuse rotierenden Rotor aufweist und der Rotor Kühlrippen aufweist, die durch eine erzwungene Konvektion angeströmt werden. Die DE 102017216241 A1 beschreibt eine LiDAR-Anordnung, bei der eine rotierende optische Einheit auch eine Kühlvorrichtung aufweist, um zur Kühlung der optoelektronischen Komponenten eine Kühlluftströmung zu erzeugen.

Ausgehend von diesem Stand der Technik ist es eine Aufgabe der Erfindung, einen optoelektronischen Sensor zur Verfügung zu stellen, der einen verbesserten Wärmeaustausch zwischen den wärmeerzeugenden Komponenten der Elektronik des Sensors und der Umgebung ermöglicht.

Diese Aufgabe wird erfindungsgemäß gelöst durch einen optoelektronischen Sensor zur Erfassung von Objekten in einem Überwachungsbereich umfassend:
- eine rotierende Optikeinheit mit mindestens einem Lichtsender zum Aussenden von Sendelichtstrahlen, mindestens einem Lichtempfänger zum Empfangen von Empfangslicht, das von Objekten im Überwachungsbereich remittiert ist, und zugehöriger Elektronik zur Steuerung der Optikeinheit,
- eine Antriebseinheit zum Rotieren der Optikeinheit,
- ein statisches Gehäuse zur Umhausung wenigstens der Optikeinheit, wobei das Gehäuse wenigstens einen Sendelichtstrahl und Empfangslicht durchlässigen Fensterbereich aufweist, und
- Wärmetausch-Elemente, die an der Optikeinheit außenseitig vorgesehen sind und derart angeordnet sind, dass die Wärmetausch-Elemente mit der Optikeinheit rotieren und Flachseiten der Wärmetausch-Elemente in einem definierten, möglichst geringen Abstand zu einer Innenseite des Gehäuses liegen, um einen konvektiven Wärmetausch mit dem Gehäuse bereitzustellen, wobei die Wärmetausch-Elemente derart ausgebildet sind, dass die Flachseiten parallel zu der Innenseite des Gehäuses verlaufen.

Durch die während der Rotation nah an der Innenseite des statischen Gehäuses entlang geführten Wärmetausch-Elemente erfolgt eine Verwirbelung der Luft zwischen den Flachseiten der Wärmetausch-Elementen und der Innenseite des Gehäuses, so dass ein verbesserter Wärmeübertrag erfolgt. Anders ausgedrückt ist der definierte Abstand so gering, damit die genannte Verwirbelung der Luft zwischen den Flachseiten der Wärmetausch-Elemente und der Innenseite des Gehäuses auftritt. Die damit einhergehende Durchmischung der Luftschichten erlaubt einen deutlich höheren Wärmeübergang zwischen den Wärmetausch-Elementen und dem Gehäuse und damit letztlich der Umgebung des Sensors. So ist ein optimaler konvektiver Wärmeübergang gewährleistet.

Die Flachseiten der Wärmetausch-Elemente verlaufen im Wesentlichen parallel zu der Innenseite des Gehäuses, um über einen größeren Bereich, also über die gesamte Flachseite eines Wärmetausch-Elementes, eine Verwirbelung und damit gute Konvektion zu erreichen.

Hierbei kann das Gehäuse zylinder-, kegel- oder kuppelförmig ausgebildet sein. Die Flachseiten haben entsprechende Form und verlaufen parallel zu der Innenseite des statischen Gehäuses in dem definierten, geringen Abstand.

Vorzugsweise liegt der definierte Abstand in einem einstelligen Millimeterbereich, insbesondere von zwei bis neun Millimetern. Dies führt vorteilhafterweise zu einer erhöhten Konvektion der Wärme zwischen den Wärmetausch-Elementen und dem Gehäuse.

Weiterhin weisen die Wärmetausch-Elemente vorzugsweise eine große Fläche auf, um Wandabschnitte am Umfang der Optikeinheit zu bilden. Insbesondere kann ein Wärmetausch-Element ein Viertel des Umfangs der Optikeinheit abdecken. Damit ist eine größere Oberfläche für den Wärmeübergang bereitgestellt. Ferner können die Wärmetausch-Elemente als Bauteile des Rotors zu einer Verbesserung der strukturellen Stabilität der Optikeinheit beitragen.

Gemäß einem bevorzugten Ausführungsbeispiel sind wenigstens zwei Wärmetausch-Elemente diametral auf dem Umfang der Optikeinheit angeordnet. Einerseits ist damit eine einfache Auswuchtung möglich und andererseits lässt das noch Raum für dazwischen angeordnete Lichtsender und Lichtempfänger der Optikeinheit mit freiem Sichtfeld und dennoch kompakten Aufbau.

Die Wärmetausch-Elemente bestehen insbesondere aus einem Material mit hoher Wärmeleitfähigkeit, vorzugsweise Aluminium oder Kupfer. In Verbindung mit der großflächigen Ausgestaltung der Wärmetausch-Elemente ist somit eine hohe und schnelle Wärmeaufnahme vom Inneren der Optikeinheit und schnelle Wärmeabgabe an das Gehäuse des Sensors erreichbar.

Vorteilhafterweise sind die Wärmetausch-Elemente wärmeleitend zum Beispiel mittels wärmeleitender Materialien, wie Wärmeleitbleche, mit den Wärmequellen der Elektronik der Optikeinheit verbunden. Die im Innern der Optikeinheit erzeugte Wärme wird damit schneller an die Wärmetausch-Elemente geleitet, so dass eine Wärmeabführung aus der Optikeinheit weiter verbessert werden kann.

Da wärmeleitende Komponenten im Motor, Lagerwelle oder Lager nicht mehr nötig sind, können entsprechende Komponenten jetzt mit der Erfindung aus Kunststoff und damit mit geringerem Gewicht gestaltet werden. Dadurch reduziert sich das Gewicht des Rotors und es kann Antriebsenergie eingespart werden.

Gemäß einem bevorzugten Ausführungsbeispiel ist der optoelektronische Sensor als Scanner, insbesondere Laserscanner, ausgebildet, der über Abstand und Winkel zum Objekt die Position des Objekts erfassen kann. Insbesondere ist die Optikeinheit ausgebildet, einen Winkel von 360° mit dem Sendelichtstrahl zu überstreichen.

Bevorzugte Ausgestaltungen und Weiterbildungen sowie weitere Vorteile der Erfindung sind den Unteransprüchen, der nachfolgenden Beschreibung und der Zeichnung zu entnehmen.

Im Folgenden wird die Erfindung anhand von Ausführungsbeispielen unter Bezugnahme auf die Zeichnung im Einzelnen erläutert. In der Zeichnung zeigen:
- Fig. 1: eine schematische Perspektiv-Darstellung eines bevorzugten Ausführungsbeispiels eines erfindungsgemäßen Sensors;
- Fig. 2: eine schematische Ansicht einer Optikeinheit des erfindungsgemäßen Sensors; und
- Fig. 3: eine Detailansicht eines bevorzugten Ausführungsbeispiels der Wärmetausch-Elemente des erfindungsgemäßen Sensors.

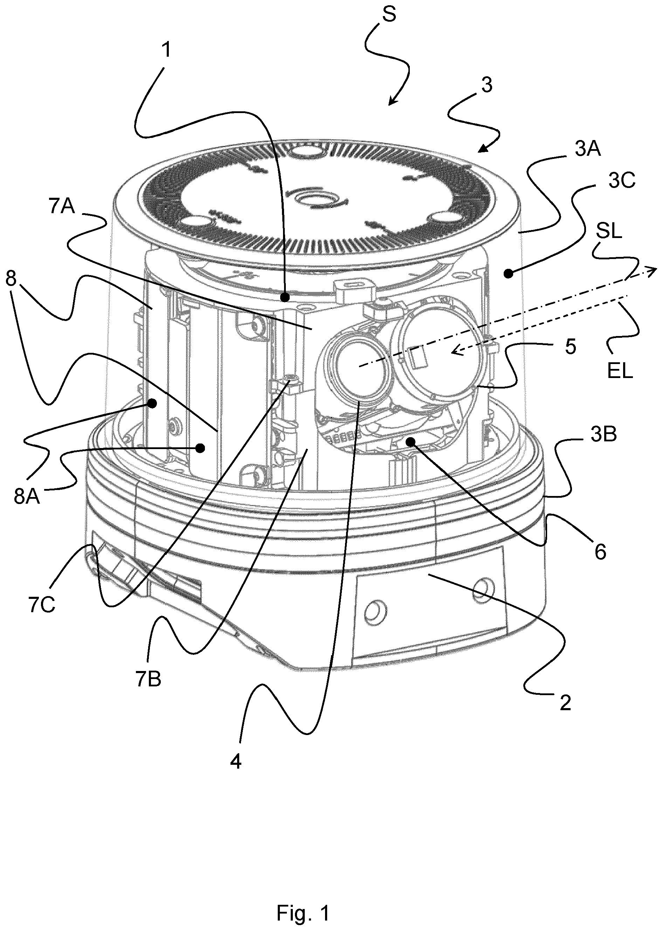

Fig. 1 zeigt eine schematische Perspektiv-Darstellung eines bevorzugten Ausführungsbeispiels eines erfindungsgemäßen Sensors S, der dafür ausgelegt ist, Objekte in einem Überwachungsbereich zu erfassen.

Der dargestellte Sensor S umfasst, in grober Aufteilung, eine rotierende Optikeinheit 1, eine Antriebseinheit 2 und ein statisches Gehäuse 3, wobei bei dem gezeigten Ausführungsbeispiel das Gehäuse 3 aus einem ersten Gehäuseteil 3A und einem zweiten Gehäuseteil 3B besteht. Das erste Gehäuseteil 3A umhaust die rotierende Optikeinheit 1 und weist wenigstens einen lichtdurchlässigen Fensterbereich 3C auf, der sich über 360° erstreckt und damit rotationssymmetrisch ausgebildet ist. Das zweite Gehäuseteil 3B umhaust die Antriebseinheit 2, die mit der Optikeinheit 1 verbunden ist, die um eine nicht dargestellte Längsachse des Sensors S rotiert.

Die Optikeinheit 1 umfasst zumindest einen Lichtsender 4, der vorzugsweise aus einem Laser gebildet ist. Der Lichtsender 4 erzeugt einen Sendelichtstrahl SL, der vorzugsweise in Form von Lichtpulsen in den Überwachungsbereich ausgesandt wird. Trifft der Sendelichtstrahl SL im Überwachungsbereich auf ein Objekt, so wird ein entsprechender Lichtstrahl als Empfangslicht EL zu dem Sensor S remittiert. Der Sendelichtstrahl SL und der Empfangslicht EL treten durch den Fensterbereich 3C des ersten Gehäuseteils 3A hindurch.

Ferner umfasst die Optikeinheit 1 mindestens einen Lichtempfänger 5, der vorzugsweise aus einem Detektorarray besteht und das Empfangslicht EL empfängt. Der empfangene Empfangslichtstrahl EL wird in ein elektrisches Empfangssignal gewandelt.

Weiterhin ist in der Optikeinheit 1 eine Elektronik 6, insbesondere zumindest eine nicht dargestellte Leiterplatte mit entsprechenden elektronischen und optoelektronische Komponenten, vorgesehen, wobei die Elektronik 6 zum Steuern, Regeln und Auswerten von Lichtsender und Lichtempfänger der Optikeinheit 1 und auch zur Kommunikation nach außen, dient. Der Lichtsender 4, der Lichtempfänger 5 und die Elektronik 6 verbrauchen elektrische Energie und bilden Wärmequellen der Optikeinheit 1, wobei die entstehende Wärme aus dem Inneren der Optikeinheit 1 über das Gehäuse 3 letztendlich an die Umgebung abgegeben werden soll.

Auf der rotierenden Optikeinheit 1 sind ein erstes und ein zweites Strukturteil 7A und 7B vorgesehen, an die der Lichtsender 4, der Lichtempfänger 5 und die Elektronik 6 montiert sind. Wie in Fig. 1 dargestellt, sind das erste und das zweite Strukturteil 7A und 7B durch Schrauben 7C miteinander verschraubt. Die Strukturteile 7A und 7B der Optikeinheit 1 bestehen vorzugsweise aus einem Material mit geringem Eigengewicht, vorzugsweise Kunststoff oder Verbundstoff, so dass die Optikeinheit 1 insgesamt leicht ausgebildet sein kann.

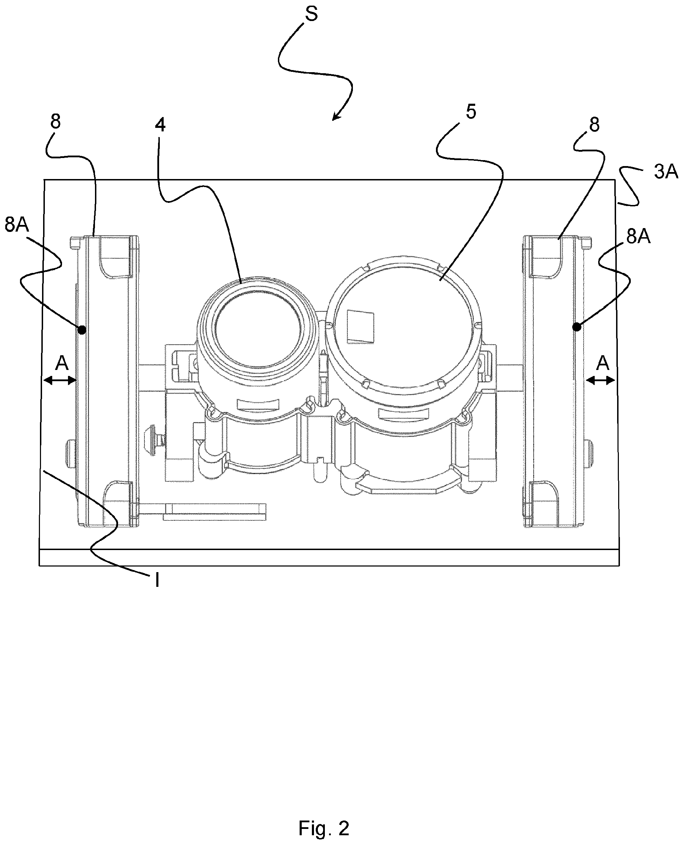

Erfindungsgemäß sind Wärmetausch-Elemente 8 an der Optikeinheit 1 außenseitig vorgesehen, so dass die Wärmetausch-Elemente 8 mit der Optikeinheit 1 rotieren. Dabei sind die Wärmetauscher-Elemente 8 derart angeordnet, dass ihre Flachseiten 8A in einem definierten Abstand A zu einer Innenseite I des Gehäuses 3, wie in der Fig. 2 dargestellt, liegen. Die Flachseiten 8A verlaufen also parallel zur Innenseite des Gehäuses 3. Die Flachseiten 8A sind dazu an die Form des Gehäuses 3 angepasst, beispielsweise entsprechend gekrümmt, wenn das Gehäuse 3, wie in dem Ausführungsbeispiel nach den Figuren, zylinderförmig ausgebildet ist. Die Flachseiten 8A haben somit dem Gehäuse 3 entsprechende Form und verlaufen parallel zu der Innenseite des statischen Gehäuses in dem definierten, geringen Abstand A. Der geringe Abstand A zwischen der stationären Innenseite des Gehäuses 3 und den rotierenden Flachseiten 8A der Wärmetauscher-Elemente 8 bewirkt eine Verwirbelung der Luft in dem Zwischenraum und verbessert damit einen konvektiven Wärmetausch mit dem Gehäuse 3.

Die Wärmetausch-Elemente 8 sind vorzugsweise als im wesentlichen viereckige Abdeckteile geformt, die großflächig mit gebogener Flachseiten 8A ausgebildet sind. Die Krümmung der gebogenen Flachseite 8A entspricht, wie erläutert, in etwa der Krümmung des ersten Gehäuseteils 3A. Die an erstem und zweitem Strukturteil 7A und 7B und am Umfang der Optikeinheit 1 befestigten Wärmetauscher-Elemente 8 bilden quasi Wandabschnitte der Optikeinheit 1. Hierdurch können die Wärmetausch-Elemente 8 zur mechanischen Stabilität der Optikeinheit beitragen.

In der Fig. 2 ist eine schematische Ansicht der Optikeinheit 1 des bevorzugten Ausführungsbeispiels des Sensors S dargestellt, wobei der Lichtsender 4, der Lichtempfänger 5 und die Wärmetausch-Elemente 8 gezeigt sind. Das erste Gehäuseteil 3A umhaust die genannten Teile.

Die wenigstens zwei Wärmetausch-Elemente 8 sind diametral auf dem Umfang der Optikeinheit 1 angeordnet. Zwischen diesen sind Optikelemente, beispielsweise Linsen und dergleichen, von Lichtsender 4 und Lichtempfänger 5 angeordnet, so dass der Sendelichtstrahl SL bzw. das Empfangslicht EL von den Wärmetausch-Elementen 8 ungehindert ausgesendet bzw. empfangen werden können.

Der definierte Abstand A ist zwischen den Flachseiten 8A der Wärmetausch-Elemente 8 und der Innenseite I des ersten Gehäuseteils 3A vorgesehen. Vorteilhafterweise liegt der definierte Abstand A im einstelligen Millimeterbereich, insbesondere von zwei bis neun Millimeter.

Im Betrieb des Sensors S, wenn also die Optikeinheit 1 rotiert, werden die Wärmetausch-Elemente 8 durch die im Inneren der Optikeinheit 1 erwärmte Luft umströmt. In dem definierten Abstand A zwischen den Flachseiten 8A der Wärmetausch-Elemente 8 und der Innenseite I des ersten Gehäuseteils 3A entsteht aufgrund des geringen Abstands A und der Rotation der Optikeinheit 1 eine Verwirbelung der Luft, was zu einem deutlich höheren konvektiven Wärmetausch zwischen den Wärmetausch-Elementen 8 und dem Gehäuse 3 und damit der Umgebung führt.

Vorteilhafterweise sind die Flachseiten 8A der Wärmetausch-Elemente 8 in etwa parallel zu der Innenseite I des Gehäuses 3 bzw. des ersten Gehäuseteils 3A angeordnet, so dass der definierte Abstand A über die gesamte Oberfläche der Flachseiten 8A in etwa gleich groß ist. Hierbei kann das erste Gehäuseteil 3A eine zylinder-, kegel- oder kuppelförmige Form aufweisen.

Die Wärmetausch-Elemente 8 bestehen aus einem Material mit hoher Wärmeleitfähigkeit, vorzugsweise Aluminium oder Kupfer. Das Material ermöglicht auch eine Reduzierung des Eigengewichts der Wärmetausch-Elemente 8.

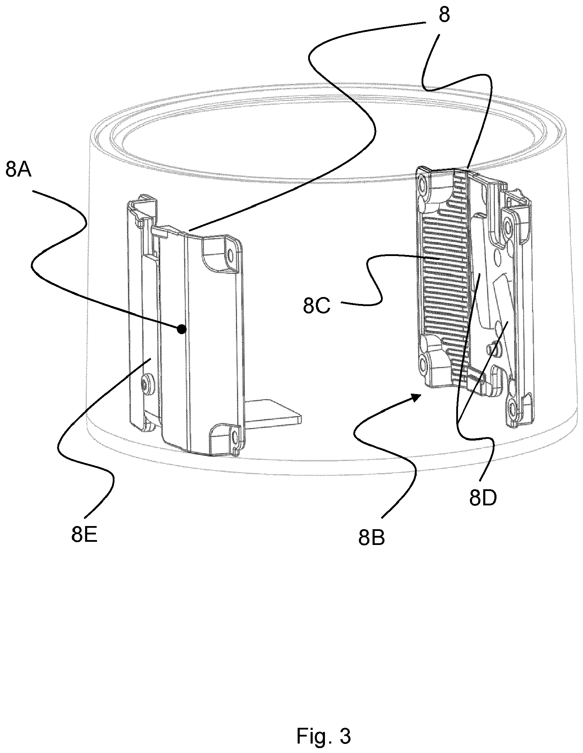

Die Fig. 3 zeigt eine schematische Perspektivansicht der Wärmetausch-Elemente 8, wobei insbesondere eine Innenseite 8B eines Wärmetausch-Elementes 8 im Detail dargestellt ist. Die Innenseite 8B des Wärmetausch-Elementes 8 weist zur Gewichtsreduzierung Rippen 8C auf. Zusätzlich können wärmeleitende Pads 8D vorgesehen sein, die an die Innenseite 8B der Wärmetausch-Elemente 8 angebracht sind.

Bei dem dargestellten bevorzugten Ausführungsbeispiel ist vorzugsweise zwischen zwei Hälften eines Wärmetausch-Elementes 8 ein Kühlkörper 8E angeordnet. Der Körperkörper 8E bzw. die Wärmetausch-Elemente 8 sind über nicht dargestellte, wärmeführende Leitungen direkt mit Wärmequellen, insbesondere der hier nicht dargestellten Elektronik 6, der Optikeinheit 1 verbunden.

Ferner können im Innern der Optikeinheit 1 vorgesehene und nicht dargestellte Wärmeleitbleche derart angeordnet sein, dass sie Wärme in Richtung der Wärmetausch-Elemente 8 leiten, so dass die Wärme schneller und direkt auf die Wärmetausch-Elemente 8 geleitet wird.

Durch die erwähnten Ausgestaltungen der Wärmetausch-Elemente 8 im Innern der Optikeinheit 1 ist eine Abführung der Wärme aus dem Innern der Optikeinheit 1 stark verbessert.

Das beschriebene bevorzugte Ausführungsbeispiel des erfindungsgemäßen Sensors S umfasst einen Scanner, insbesondere einen Laserscanner, der ausgebildet ist, eine Entfernung zwischen dem nicht dargestellten Objekt und dem Scanner und einen Winkel des Objektes zu einem Nullwinkel des Scanners zu erfassen. Bei dem Scanner ist die Optikeinheit 1 ausgebildet, einen Winkel von 360° mit dem Sendelichtstrahl SL zu überstreichen.

### Bezugszeichenliste

- 1: Optikeinheit
- 2: Antriebseinheit
- 3: Gehäuse
- 3A: erstes Gehäuseteil
- 3B: zweites Gehäuseteil
- 4: Lichtsender
- 5: Lichtempfänger
- 6: Elektronik
- 7A: erstes Strukturteil
- 7B: zweites Strukturteil
- 7C: Schrauben
- 8: Wärmetausch-Element
- 8A: Flachseite des Wärmetausch-Elementes
- 8B: Innenseite des Wärmetausch-Elementes
- 8C: Rippen
- 8D: Wärmepads
- 8E: Kühlkörper

- A: definierter Abstand
- EL: Empfangslicht
- I: Innenseite des Gehäuses
- S: optoelektronischer Sensor
- SL: Sendelichtstrahl

## Patentansprüche

1. Optoelektronischer Sensor (S) zur Erfassung von Objekten in einem Überwachungsbereich, umfassend
- eine rotierende Optikeinheit (1) mit mindestens einem Lichtsender (4) zum Aussenden von Sendelichtstrahlen (SL), mindestens einem Lichtempfänger (5) zum Empfangen von Empfangslicht (EL), das von Objekten im Überwachungsbereich remittiert ist, und zugehöriger Elektronik (6) zur Steuerung der Optikeinheit (1),
- eine Antriebseinheit (2) zum Rotieren der Optikeinheit (1),
- ein statisches Gehäuse (3) zur Umhausung wenigstens der Optikeinheit (1), wobei das Gehäuse (3) wenigstens einen Sendelichtstrahl und Empfangslicht (SL und EL) durchlässigen Fensterbereich (3C) aufweist, und
- Wärmetausch-Elemente (8), die an der Optikeinheit (1) außenseitig vorgesehen sind und derart angeordnet sind, dass die Wärmetausch-Elemente (8) mit der Optikeinheit (1) rotieren und Flachseiten (8A) der Wärmetausch-Elemente (8) in einem definierten Abstand (A) zu einer Innenseite (I) des Gehäuses (3) liegen, um einen konvektiven Wärmeaustausch mit dem Gehäuse (3) bereitzustellen, wobei die Wärmetausch-Elemente (8) derart ausgebildet sind, dass die Flachseiten (8A) parallel zu der Innenseite (I) des Gehäuses (3) verlaufen.

2. Optoelektronischer Sensor (S) nach Anspruch 1, wobei die Wärmetausch-Elemente (8) jeweils eine große Fläche aufweisen, um Wandabschnitte am Umfang der Optikeinheit (1) zu bilden.

3. Optoelektronischer Sensor (S) nach einem der vorhergehenden Ansprüche 1 bis 2, wobei wenigstens zwei Wärmetausch-Elemente (8) diametral auf dem Umfang angeordnet sind, so dass Optikelemente des Lichtsenders (4) und des Lichtempfängers (5) zwischen den Wärmetausch-Elemente (8) angeordnet sind.

4. Optoelektronischer Sensor (S) nach einem der vorhergehenden Ansprüche, wobei der definierte Abstand (A) in einem einstelligen Millimeterbereich, vorzugsweise zwei bis neun Millimeter, liegt.

5. Optoelektronischer Sensor (S) nach einem der vorhergehenden Ansprüche, wobei die Wärmetausch-Elemente (8) aus einem Material mit hoher Wärmeleitfähigkeit, vorzugsweise Aluminium oder Kupfer, bestehen.

6. Optoelektronischer Sensor (S) nach einem der vorhergehenden Ansprüche, wobei die Wärmetausch-Elemente (8) über wärmeführende Leitungen mit Wärmequellen, insbesondere der Elektronik (6), der Optikeinheit (1) verbunden sind.

7. Optoelektronischer Sensor (S) nach einem der vorhergehenden Ansprüche, wobei tragende Strukturteile (7A, 7B) der Optikeinheit (1) aus einem Material mit geringem Eigengewicht, vorzugsweise Kunststoffe oder Verbundstoffe, bestehen.

8. Optoelektronischer Sensor (S) nach einem der vorhergehenden Ansprüche, wobei im Innern der Optikeinheit (1) vorgesehene Wärmeleitbleche derart angeordnet sind, so dass sie heiße Luft in Richtung der Wärmetausch-Elemente (8) leiten.

9. Optoelektronischer Sensor (S) nach einem der vorhergehenden Ansprüche, wobei der Sensor (1) ein Scanner, insbesondere ein Laserscanner, ist, der ausgebildet ist, eine Position eines Objekts zu erfassen.

10. Optoelektronischer Sensor (S) nach einem der vorhergehenden Ansprüche, wobei die Optikeinheit (1) ausgebildet ist, einen Winkel von 360° mit dem Sendelichtstrahl (SL) zu überstreichen.
